Europäisches Patentamt

(19) **European Patent Office**

Office européen des brevets

(11) Publication number: **0 066 971**
**A2**

## (12) EUROPEAN PATENT APPLICATION

(21) Application number: **82302473.2**

(22) Date of filing: **14.05.82**

(51) Int. Cl.³: **C 30 B 11/14,** C 30 B 29/52, B 22 D 27/04

(30) Priority: **08.06.81 US 271812**

(43) Date of publication of application: **15.12.82**
**Bulletin 82/50**

(84) Designated Contracting States: **BE CH DE FR GB IT LI SE**

(71) Applicant: **TRW INC., 23555 Euclid Avenue, Cleveland Ohio 44117 (US)**

(72) Inventor: **Vishnevsky, Constantine, 5940 Buckboard Lane, Solon Ohio 44139 (US)**
Inventor: **Kolakowski, Thomas Alan, 34900 Jackson Road, Moreland Hills Ohio 44022 (US)**

(74) Representative: **Abbie, Andrew Kenneth et al, A.A. Thornton & Co 303-306 High Holborn, London WC1V 7LE (GB)**

(54) **Method of casting an article.**

(57) An airfoil containing metal article is cast with portions having unit cells with different orientations. The leading and trailing edge portions of the airfoil are cast with cubic unit cells having an [001] direction extending substantially parallel to the longitudinal axis of the article in order to promote thermal fatigue resistance. The central portion of the airfoil has unit cells with a [111] orientation with respect to the longitudinal axis in order to improve the creep strength and Young's modulus of the airfoil. The leading and trailing edge portions and central portion of the airfoil may be cast with elongated crystals or may be cast with each of the portions formed as a single crystal. To cast the airfoil containing metal article, a starter element having portions with unit cells oriented in different directions is placed in an open end portion of a mold with the starter element exposed to both a mold cavity and a chill. Molten metal is poured against the starter element and crystals are nucleated with unit cells having orientations corresponding to the orientations of the unit cells in the portion of the starter element engaged by the molten metal. The molten metal which is solidified to form the leading and trailing edge portions of an airfoil engages a portion of the starter element in which the unit cells have [001] orientations with respect to the longitudinal axis of the airfoil. The molten metal which is solidified to form the central portion of the airfoil engages a portion of the starter element which has unit cells oriented in a [111] direction with respect to the longitudinal axis of the airfoil.

ACTORUM AG

- 1 -

## METHOD OF CASTING AN ARTICLE

### Background of the Invention

The present invention relates to an improved method of casting an improved article and more specifically to a method of casting a metal article, such as a turbine blade or vane, with portions having cubic unit cells with different orientations.

The concept of casting an article, such as a turbine blade, with elongated crystals having a desired [001] direction parallel to the longitudinal axis of the article is disclosed in U.S. Patent Nos. 3,417,809; 3,485,291; and 3,572,419. The method disclosed in these patents is characterized by initial solidification of the molten metal occurring in a competitive growth zone adjacent to a chill with the longitudinal direction of th article's mold cavity being aligned perpendicular to the chill surface.

This competitive growth zone occurs because when a face-centered cubic metal is cast against a chill, the initial crystals which are formed will not all have the desired [001] orientation, but rather will be substantially randomly aligned. Since solidifying dentrites in the molten metal grow most favorably in the [001] direction, as solidification proceeds from the chill, those dentrites having an [001] orientation perpendicular to the chill will grow preferentially along the longitudinal axis of the article. Eventually, the preferred dentrites will emerge from the competitive growth zone and result in a series of columnar grains or crystals having an [001] direction oriented in the growth direction. The function of the growth zone from which the preferred or [001] aligned columnar grains emerge is to eliminate from the cast article crystals or grains having an off axis orientation.

Although the [001] direction of crystallographic orientation which results from directional solidification in the manner disclosed in the aforementioned patents has certain desirable characteristics, such as improved thermal fatigue resistance, it is well known that other crystallographic directions of orientation can yield higher creep strength and Young's modulus values. For certain applications, higher creep strength and Young's modulus values can be important. However, the obtaining of the crystallographic directions of orientation which yield the higher strength and Young's modulus values cannot be done with conventional directional solidification techniques.

In the past, crystal orientation during the casting of a single crystal article has been controlled through the use of seeds or solid pieces of single crystal material. During casting, metal solidification proceeds from the single crystal seed and causes propagation of a single crystal in an entire casting cavity. Control of the seed temperature and suitable means of cooling the molds are needed to achieve the desired effect in a manner which is further described in U.S. Patent Nos. 1,793,672; 3,139,653; 3,759,310; 3,857,436; and 4,015,657. However, the methods disclosed in these patents have used single crystal seeds to cause the formation of single crystal articles rather than directionally solidified articles having a plurality of elongated crystals with the desired crystallographic orientation.

In an effort to obtain an article having an elongated crystal structure with a multiplicity of oriented grains or crystals, British Patent No. 870,213 teaches the use of a seed slab or starter in the manufacture of ingots having preferred crystallographic properties. The seed slab or starter element has elongated grains oriented so that the (100) crystallographic planes, which correspond to the sides of body-centered unit cells, are substantially perpendicular to the longitudinal axes of elongated grains or crystals of the seed slab. The other sides of the unit cells, that is the sides which extended parallel to the longitudinal axes of the grains or crystals, are randomly oriented and are only occasionally parallel to similar crystal planes in other elongated grains or crystals.

During a casting operation, the seed slab or starter element of the British patent is placed at the bottom of a mold with the longitudinal axes of the crystals extending horizontally, that is perpendicular to the longitudinal axis of the mold. Molten metal is then poured into the mold cavity against the seed slab. The resulting directionally solidified article is formed of elongated crystals or grains having unit cells oriented so as to have a pair of side surfaces extending perpendicular to the longitudinal axes of the crystals or grains and other side surfaces extending parallel to the longitudinal axis of the crystals or grains. The crystallographic orientation along the longitudinal axis is [001], the same as produced through directional solidification in the making of aforemention gas turbine articles by competitive crystal growth from a chill surface. Hence, this art does not teach how, for polycrystalline articles, directions other than [001] could be achieved along the longitudinal axis of the article, cast perpendicular to the chill surface, in order to obtain desired changes in strength or Young's modulus.

## Brief Summary of the Present Invention

The present invention provides a new and improved method of forming new and improved cast metal articles. Although it is contemplated that many different improved articles could be formed with the improved method, the method is advantageously used to form airfoil containing articles such as the blades or vanes used in gas turbine engines. These articles are typically produced from nickel-base superalloys and have a so-called face-centered cubic crystal structure. The improved cast article, whether it be a blade or vane, is provided with portions having cubic unit cells with different orientations. This is achieved by initiating solidification of the article during a casting operation with a starter element having crystals with unit cells oriented in different directions. The different directions of orientation of the unit cells in the starter element result in nucleation and growth of crystals in the cast article having unit cells with different orientations in different portions of the article.

The operating characteristics of a gas turbine blade or vane are enhanced by forming the airfoil region with leading and/or trailing edge portions having unit cells oriented in one direction and a central portion with unit cells oriented in another direction. Thus, an airfoil portion can be cast with the leading and/or trailing edges having cubic unit cells oriented with an [001] direction parallel to the longitudinal axis of the airfoil in order to enhance thermal fatigue resistance of the leading and/or trailing edge portions. Although the [001] unit cell orientation is advantageous from a thermal fatigue standpoint, it is not optimal from a creep strength standpoint. In order to achieve better strength, the central portion of the airfoil advantageously has unit cells oriented in the [111] direction being parallel to the longitudinal axis of the airfoil.

An airfoil having leading and/or trailing edge portions with unit cells oriented in the [001] direction and a central portion oriented in the [111] direction can advantageously be cast with each of the portions being formed of either a plurality of elongated crystals or a single crystal. When the airfoil is cast with the leading and trailing edge portions and central portion each being formed of more than one elongated crystal, the longitudinal axes of the crystals extend parallel to each other and to the central axes of the edge portions and central portion of the airfoil. When the airfoil is formed with single crystal edge and central portions, the central portion and the leading and/or trailing edge portion of the airfoil are each formed as single crystals. This can result in the airfoil being formed of three single crystals, that is a single crystal leading edge portion, a single crystal trailing edge portion, and a single crystal central portion extending between the leading and trailing edge portions. Although the present invention is advantageously practiced in connection with various types of airfoils, the invention can be practiced in connection with other articles.

Accordingly, it is an object of this invention to provide a new and improved method of forming new and improved articles with portions having cubic unit cells with different orientations.

Another object of this invention is to provide a new and improved method of forming new and improved articles as set forth in the preceding object and wherein a starter element having portions with unit cells of the same orientation as the orientation of the unit cells in an article is used during the casting of the article.

Another object of this invention is to provide a new and improved method of forming a new and improved airfoil containing article, such as a gas turbine blade or vane, and wherein a starter element has a portion with unit cells oriented in an [001] direction parallel to the longitudinal axis and another portion with unit cells oriented in a [111] direction parallel to the longitudinal axis to effect solidification of molten metal with unit cells having similar orientations in the resulting article.

Another object of this invention is to provide a new and improved airfoil having leading and trailing edge portions formed as single crystals and a central portion extending between the leading and trailing edge portions and also formed as a single crystal.

Another object of this invention is to provide a new and improved method of forming a new and improved airfoil having longitudinally extending leading and trailing edge portions and a central portion and wherein different portions of the airfoil are formed with cubic unit cells having different orientations.

### Brief Description of the Drawings

The foregoing and other objects and features of the present invention will become more apparent upon a consideration of the following description taken in connection with the accompanying drawings wherein:

Fig. 1 is a schematic illustration depicting the manner in which a mold is supported on a chill with starter elements exposed to the chill and to mold cavities prior to pouring of molten metal into the mold;

Fig. 2 is an enlarged fragmentary sectional view illustrating the relationship between a starter element, a mold cavity, and a chill of Fig. 1, the orientation of unit cells of the starter element being indicated schematically;

Fig. 3 is an illustration of an improved airfoil containing aticle, a so-called blade, cast with the starter element of Fig. 2 and schematically illustrating the orientation of cubic unit cells in elongated grains or crystals in different portions of the article and specifically the airfoil portion;

Fig. 4 is an enlarged schematic illustration further illustrating the orientation of cubic unit cells in leading and trailing edge portions of the airfoil of Fig. 3, the structure of the unit cell being simplified for purposes of clarity of illustration;

Fig. 5 is an enlarged schematic illustration further illustrating the orientation of cubic unit cells in a central portion of the airfoil of Fig. 3, the structure of the unit cell being simplified for purposes of clarity of illustration;

Fig. 6 is an enlarged fragmentary sectional view, generally similar to Fig. 2, illustrating the relationship between a starter element, a mold cavity and a chill; and

Fig. 7 is an illustration, generally similar to Fig. 3, of an improved airfoil containing article, that is a blade, cast with the starter element of Fig. 6 and schematically illustrating the orientation of unit cells in single crystals which form leading and trailing edge portions and a central portion of the article and specifically the airfoil portion.

## Description of Specific
## Preferred Embodiments of the Invention

Casting Apparatus

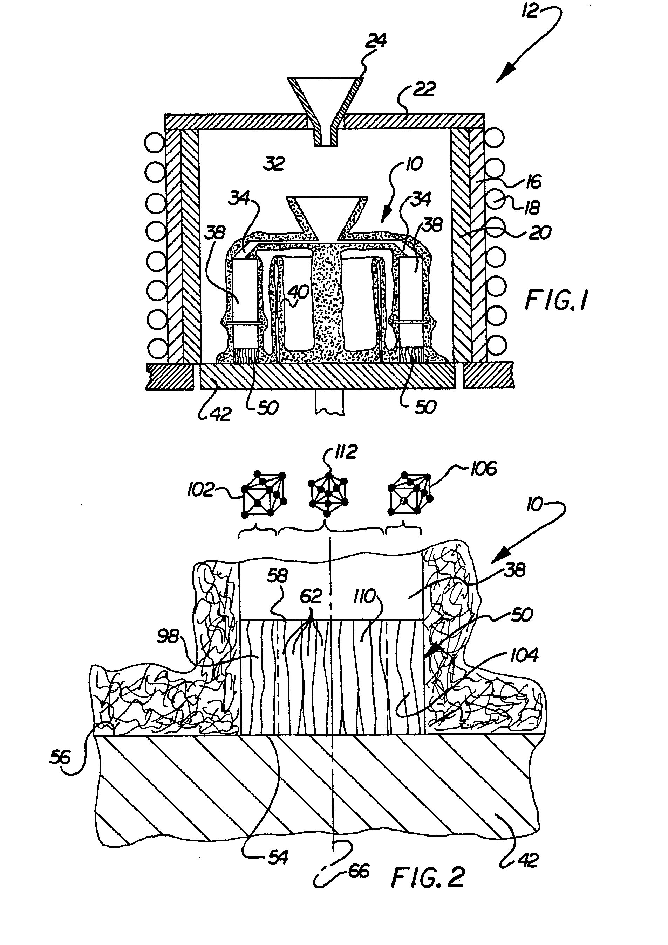

A mold 10 (Fig. 1) is preheated in a known furnace assembly 12 prior to pouring of molten metal into the mold. The furnace assembly 12 is provided with a refractory outer wall 16 which is surrounded by an induction heating coil 18. A graphite susceptor wall 20 is enclosed by the outer wall 16 and is heated by the induction effect of the coil 18. The furnace assembly 12 has a top plate 22 with a funnel 24 through which molten metal is poured into the mold 10. It is contemplated that the entire furnace assembly 12 will be disposed within a vacuum furnace.

The mold 10 has a pouring basin 32 through which molten metal enters a plurality of runners or passages 34 which are connected with a plurality of mold cavities 38 which are disposed in a circular array around the pouring basin 32. A cylindrical heat shield 40 may be provided on the inside of the circular array of mold cavities 38.

The mold 10 is disposed on a copper chill plate 42. The chill plate 42 promotes the directional solidification of molten metal in the mold cavities to provide a casting having a columnar grain structure with a grain orientation extending generally parallel to the longitudinal central axes (vertical axes) of the mold cavities 38. It should

0066971

be noted that although the furnace 12 and mold 10 could have many different constructions, they have the same general construction as the furnace and mold disclosed in U.S. Patent No. 3,680,625.

A starter element 50 (see Fig. 2) is positioned in the lower end portion of the mold cavity 38. The cylindrical starter element 50 is exposed both to the chill 42 and to the mold cavity 38. Thus, a lower or bottom side surface 54 of the starter element 50 is disposed in abutting engagement with an upper or top side surface 56 of the chill 42. The opposite side surface 58 of the starter element 50 is directly exposed to the mold cavity 38.

When molten metal is poured into the funnel 24 and basin 32 to the runners 34 and mold cavity 38, the molten metal flows downwardly against the upper side surface 58 of the starter element 50. Due to the rapid conduction of heat from the starter element 50 to the chill 42, solidification of the molten metal in the mold cavity 38 is initiated at the upper side surface 58 of the starter element 50. As solidification of the molten metal proceeds upwardly in the mold cavity 38, the chill 42 and mold 10 are advantageously lowered to withdraw the mold from the furnace 12 in a known manner.

Starter Element

The starter element 50 is formed of a plurality of parallel elongated metal crystals or grains 62 (see Fig.

2) having longitudinal axes which are substantially perpendicular to the opposite side surfaces 54 and 58 of the starter element. The large majority of the grains 62 extend completely through the starter element 50.

The elongated grains 62 have one transverse end disposed in the side surface 54 and the opposite transverse end disposed in the side surface 58. A few of the longitudinally extending grains 62 may terminate between the two side surfaces 54 and 58. However, all of the grains which end at the side surface 58 have an opposite end at the side surface 54. The elongated grains or crystals 62 have longitudinal axes which are disposed in a parallel relationship with a longitudinal central axis 66 of the mold cavity 38. The construction and method of using the starter element 50 is the same as is described in copending application Serial No. 239,640 filed by Constantine Vishnevsky and Thomas A. Kolakowski on March 2, 1981 and entitled "Method of Casting an Article", and the disclosure therein is hereby incorporated herein by this reference thereto.

Crystal Nucleation-Elongated Crystals

Since the elongated crystals 62 have ends disposed in the upper surface 58 of the starter element 50, each of the starter element crystals can effect nucleation of a corresponding longitudinally extending crystal or grain in the molten metal in the mold cavity 38 upon initiation of solidification of the molten metal. This results in the molten metal in the cavity 38 solidifying in a multiplicilty of longitudinally extending crystals or grains. The crystals have their origin at the surface 58 of the starter element 50. The crystals grow upwardly in a direction parallel to a longitudinal central axis 66 of the mold cavity 38.

The elongated crystals which are solidified in the mold cavity 38 have longitudinal axes which extend parallel to the mold axis 66 (Fig. 2) and the longitudinal axes of the grains 62 in the starter element 50. Due to nucleation of the grains in the cast product in the desired orientation at the end surface 58 of the starter element, the competitive growth zone which characterizes many known directional solidification processes when the desired longitudinal direction is [001] can be eliminated.

In accordance with a feature of the present invention, the starter element 50 is effective in nucleating crystals or grains having unit cells with different orientations. By providing different portions of a cast article or product with unit cells having different orientations, the physical characteristics of different portions of the cast article will be different. This enables the overall operating characteristics of the cast article to be enhanced since the physical and mechanical characteristics of the different portions of the article can be optimized for the particular operating conditions to which that portion of the article is exposed.

Unit Cells-Elongated Crystals

The unit cell, the fundamental building block of the crystal, has an atomic arrangement which, when repeated in three dimensions, gives the total structure of the crystal. The configuration of the unit cell will vary depending upon the material from which the crystal is formed. For the nickel-base superalloy forming the airfoil containing article 72, the unit cell has a face-centered cubic configuration which consists of an atom at each cube corner and one at the center of each face, as depicted in Figs. 2, 3, 6 and 7. The orientations within each unit cell is specified in terms of its coordinates relative to orthogonal X, Y and Z axes. When specifying directions in a crystal the notation [XYZ] is used to indicate the direction of a line from the origin to a point the coordinates are X, Y and Z. By custom, brackets are utilized and fractional coordinates are avoided.

Thus, a direction along one of the edges of the cubic cell would also be parallel to one of the three axes and would be denoted as [100], [$\bar{1}$00], [010], [0$\bar{1}$0], [001], or [00$\bar{1}$]. In each case, the minus notation above the numeral denotes a negative direction from the origin. Each of these directions is said to be equivalent and of the ⟨100⟩

family. Crystals whose longitudinal axes are vertically aligned and in which one of the unit cell axes is also vertically aligned are said to have an [001] orientation, reflecting the convention of denoting the vertical axis as Z. The spatial position of the unit cell may be simply visualized as that of a cube lying flat on one of its faces with the longitudinal central axis 118 being perpendicular to the horizontal plane on which the cube rests.

An extreme form of unit cell orientation occurs in a direction joining the diagonally opposite corners of the cube. This may be visualized as a cube so positioned that one corner makes point contact with a horizontal surface and the other, diagonally opposite, corner falls on a line that both joins the two corners and is perpendicular to the supporting horizontal surface. There are several such equivalent directions in a cubic unit cell, all part of the $\langle 111 \rangle$ family. A crystal in which a direction of this family is parallel to the longitudinal central axis 118 is said to have a [111] orientation. Intermediate between these two extreme orientations of [001] and [111], numerous others are possible. The notation accorded these is well known in the field of crystallography and is not essential to delineating the features of this invention.

Turbine engine blades and vanes produced by the process of directional solidification wherein metal is solidified in contact with a horizontally disposed copper chill typically involve the use of nickel-base superalloys having a face-centered cubic crystal structure. The resulting orientation of elongated crystals in this process is [001]. The side surfaces or faces of the unit cells lie either perpendicular or parallel to the longitudinal central axis 118 of the airfoil containing article 72. By virtue of its low Young's modulus this orientation is recognized as superior from the standpoint of thermal fatigue resistance. However, other orientations, particularly the [111], offer the possibility of greatly improved Young's modulus without sacrifice in creep strength. In cubic crystals the [111] orientation provides the highest value of Young's modulus. At ambient temperature for nickel this value is approximately 44,000,000 psi versus approximately 18,000,000 psi for an [001] orientation. High creep strength has also been reported for the [111] orientation as measured by creep rates and stress rupture lives at elevated temperatures on tests performed using individual crystals of nickel-base superalloys. Depending on the alloy and specific test conditions of stress and temperature, the [111] orientation has been found to provide considerably less primary creep versus that of an [001] orientation and stress rupture lives that are comparable to and, in some cases, superior to those seen with an [001] orientation. Using available data for two nickel-base superalloys, one published study postulates that the [111] orientation provides the highest creep resistance and rupture lives in comparison with [001] or other orientations.

In accordance with a feature of the present invention the operating characteristics of an article are enhanced by forming the article of elongated metal crystals with one group of crystals having unit cells with one orientation and another group of crystals having unit cells with a different orientation. In order to cast an article having different portions with crystals having unit cells with different orientations, the starter element 50 (Fig. 2) has portions in which the elongated metal crystals 62 have unit cells with different orientations.

The elongated metal crystals 62 effect the nucleation in a cast article of crystals having unit cells with the same orientation as the unit cells of the starter element crystals which initiated nucleation of the cast article crystals. Therefore by providing the starter element 50 with elongated crystals 62 located relative to each other so that the nucleation of cast article crystals having unit cells with a desired orientation is effected, the cast article can be formed with preselected portions having elongated crystals with unit cells arranged in preselected orientations.

Airfoil-First Embodiment

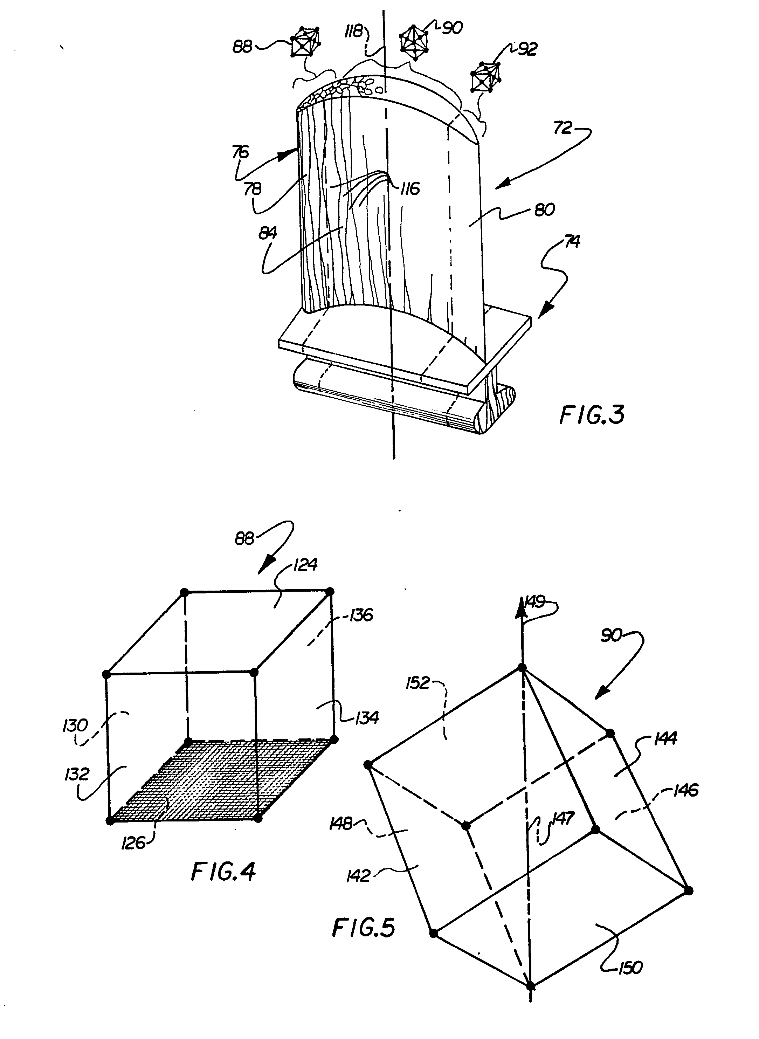

Although the present method could be used to form many different types of cast articles, the method is advantageously used to form an airfoil containing article, such as a blade 72 (Fig. 3), which is used in a gas turbine engine. The blade 72 includes a base or platform 74 and an airfoil 76 which is integrally cast with the base 74. The one-piece airfoil 76 has a leading edge portion 78 and a trailing edge portion 80. The leading and trailing edge portions 78 and 80 are interconnected by a central portion 84. It should be noted that for the article shown the crystal structues of the leading edge portion 78, the trailing edge portion 80, and the central portion 84 of the airfoil 76 extend through the base or platform 74.

In order to enhance the operating characteristics of the blade 72, the cubic unit cells in the leading and trailing edge portions of the airfoil 76 and of the blade 72 are oriented with an [001] direction being parallel to the central axis 118 of the blade and the cubic unit cells in the central portion 84 of the airfoil are oriented with a [111] direction parallel to central axis 118. The orientation of the unit cells in the leading and trailing edge portions 78 and 80 and central portion 84 of the airfoil 76 have been indicated schematically by cubic unit cells 88, 90 and 92 in Fig. 3. These crystal orientations extend from the lower end of the airfoil 76 through the base 74.

The leading and trailing edge portions 78 and 80 of the blade are advantageously formed of a plurality of elongated metal crystals having unit cells with an [001] orientation which is indicated schematically by the unit cells 88 and 92. The [001] unit cell orientation in the elongated crystals of the leading and trailing edge portions 78 and 80 of the blade enhances thermal fatigue resistance to retard the formation of thermal fatigue cracks.

The central portion 84 of the airfoil 76 of the blade 72 is formed of a plurality of elongated metal crystals having unit cells with a [111] orientation indicated schematically by the unit cell 90 in Fig. 3. By forming the central portion 84 of the airfoil with unit cells having a [111] direction parallel to the central axis 118 of the airfoil 76 and blade 72, the creep resistance and Young's modulus of the central portion 84 of the airfoil 76 is greater than the creep resistance and Young's modulus of the edge portions 78 and 80 of the airfoil. However, the thermal fatigue resistance of the central portion 84 of the airfoil is not so great as the thermal fatigue resistance of the leading and trailing edge portions 78 and 80 of the airfoil. Since thermal fatigue cracks tend to form in the leading and/or trailing trailing edge portions of the airfoil 76, this construction of the blade 72 reduces the tendency for thermal fatigue cracks to form in the leading and trailing edge portions 78 and 80 of the airfoil while the overall creep strength of the central portion 84 of the airfoil is enhanced.

Casting the Airfoil Containing Article.

In order to cast the leading and trailing edge portions 78 and 80 of the airfoil 76 with cubic unit cells having an [001] orientation and to form the central portion of the blade with cubic unit cells having a [111] orientation, the starter element 50 (Fig. 2) has portions with cubic unit cells having orientations corresponding to the desired orientations of the unit cells in the airfoil 76. The portion of the starter element 50 indicated at 98 in Fig. 2 initiates nucleation of the longitudinally extending metal crystals which form the leading edge 78 of the directionally solidified airfoil 76. Therefore, the unit cells in the elongated metal crystals 62 in the portion 98 of the starter element 50 have cubic unit cells, indicated schematically at 102 in Fig. 2, with an [001] direction parallel to the central axis 66 of the mold cavity 38 and the starter element. Similarly, the portion 104 of the starter element 50 initiates directional solidification of the trailing edge portion 80 of the airfoil 76 and has elongated metal crystals 62 with cubic unit cells with the [001] direction parallel to the axis 66.

A central portion 110 of the starter element 50 initiates nucleation of the longitudinally extending metal crystals which form the central portion 84 of the directionally solidified airfoil 76. Therefore, the elongated metal crystals 62 of the portion 110 of the starter element 50 have cubic unit cells, indicated schematically at 112 in Fig. 2, with a [111] direction parallel to the axis 66. The foregoing crystal orientations of the portions 98, 104 and 110 extend between the top and bottom surfaces 54 and 58 of the starter element.

When a molten nickel-base superalloy is poured into the mold cavity 38, the molten metal engages the upper surface 58 of the starter element 50. The elongated metal crystals 62 in the starter element 50 initiate the formation of elongated metal crystals 116 of the airfoil containing article, namely blade 72. The elongated crystals 116 of the blade 72 extend parallel to the longitudinal central axis 118 of the blade 72 and airfoil 76 and to the coincident longitudinally extending central axis 66 of the mold cavity 38.

Since the molten metal engages the transverse end portions of the elongated metal crystals 62 in the starter element 50, the starter element is effective to immediately initiate the solidification of similarly oriented elongated metal crystals to form the blade 72.

The elongated crystals 116 in the blade 72 are nucleated at the upper ends of the elongated metal crystals 62 of the starter element 50. Therefore, the elongated metal crystals 116 in the blade 72 have unit cells with the same orientation as the unit cells of the elongated crystals 62 in the starter element which initiate their solidification.

The solidification of the elongated metal crystals 116 that appear at the leading and trailing edge portions 78 and 80 of the airfoil 76 is initiated by the spaced apart portions 98 and 104 (Fig. 2) of the starter element 50. Since the portions 98 and 104 of the starter element 50 have unit cells with an [001] orientation, the elongated metal crystals which solidify to form the edge portions 78 and 80 of the airfoil 76 also have unit cells with an [001] orientation. The elongated metal crystals 62 in the central portion 110 of the starter element 50 have unit cells with a [111] orientation. This results in the solidification of elongated metal crystals 116 having unit cells with a [111] orientation in the central portion 84 of the blade 72 including the associated airfoil portion 76. It is contemplated that in practice the width in the edge to edge direction of the central portion 84 will not remain constant but will tend to decrease with increasing distance from the chill. Similarly, the edge portions 78 and 80 will tend to increase in width with increasing distance from the chill.

Each of the elongated metal crystals 116 in the leading edge portion 78 of the airfoil 76 is formed of a plurality of unit cells, all of which have the [001] orientation of the unit cell 88 (see Fig. 4). Although the blade 72 is formed of a nickel base super alloy having face-centered cubic unit cells, the representation of the unit cell 88 has been simplified in Fig. 4 for purposes of clarity of illustration.

The unit cell 88 has upper and lower sides 124 and 126 which extend perpendicular to the longitudinal central axis of an elongated metal crystal 116 and to the axis 118 of the blade 72. The cubic crystal 88 has four sides 130, 132, 134 and 136 (Fig. 4) which are disposed in a rectangular array and extend parallel to the longitudinal central axis of an elongated metal crystal 116 and the central axis 118 of the blade 72. This orientation of the unit cell 88 relative to the central axis of an elongated crystal 116 is the same as the orientation of the unit cell 102 (Fig. 2) relative to the central axis of an elongated metal crystal 62 in the starter element 50. The resulting arrangement of the unit cells 88 enhances the thermal fatigue resistance of the leading edge portion 78 of the airfoil to retard the formation of thermal fatigue cracks in the leading edge portion.

The trailing edge portion 80 of the airfoil 76 has a crystallographic construction which is the same as the construction as the leading edge portion 78 of the
airfoil.  Thus, the trailing edge portion 80 of the
airfoil is formed of elongated metal crystals 116 which
extend parallel to each other and to the central axis 118
of the blade.  The unit cells 92 of each of the metal
crystals 116 in the trailing edge portion 80 have parallel
top and bottom sides which extend perpendicular to the
central axes of the elongated crystals and to the blade
axis 118.  In addition, the unit cells 92 have sides which
are equivalent to the sides 130-136 of the metal crystal
88 and which extend parallel to the central axes of the
crystals 116.

Within an individual elongated crystal 116 of a
leading edge portion 78 or trailing edge portion 80 all
unit cells have a common rotational orientation with
regard to the longitudinal central axis 118 such that the
corresponding side surfaces of all unit cells are
parallel.  Although other elongated crystals 116 need not
share the same rotational orientation, a common
longitudinal orientation of [001] exists, imparting within
the leading and trailing edge portions of the blade 72 and
corresponding airfoil 76 a common set of Young's modulus
and other mechanical behavior characteristics.

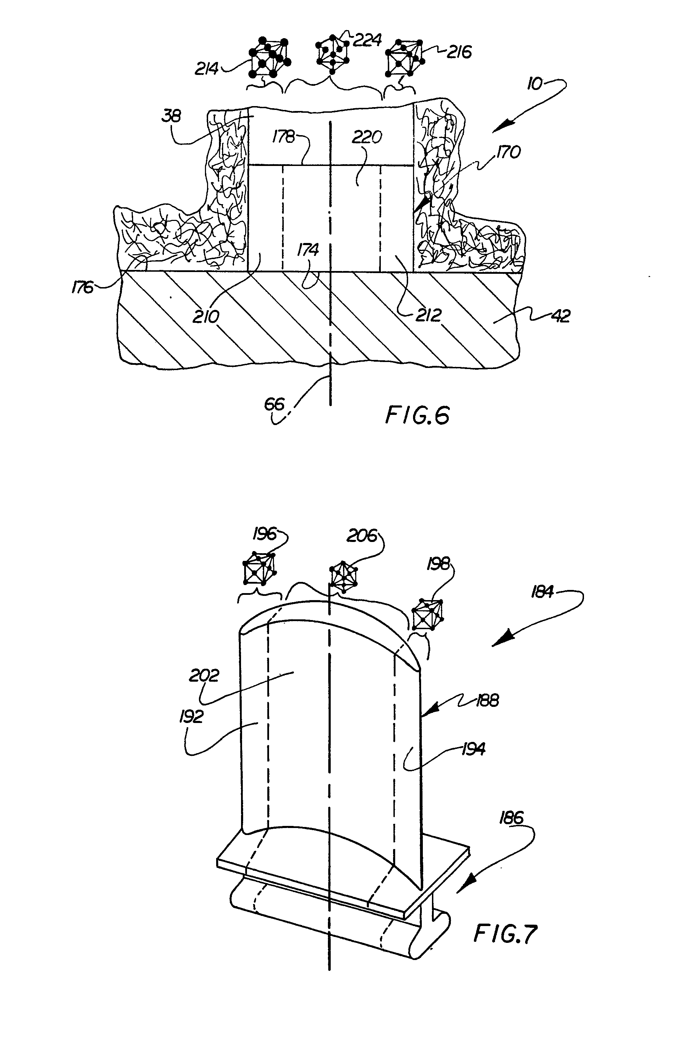

The unit cells 90 (Fig. 5) in the central portion 84
blade 72 and associated airfoil 76 have a [111]
orientation.  A unit cell 90 having this orientation has been illustrated schematically in Fig. 5. It should be noted that, although the unit cell 90 is of the face-centered cubic construction, only the lattice points at the corners of the unit cell 90 have been illustrated in Fig. 5, the lattice points at the center of each face being omitted for purposes of clarity of illustration. In Fig. 5, the [111] direction, parallel to the longitudinal axis of the crystals 116 and longitudinal central axis 118 of the blade 72, is denoted by the arrow 149.

When the unit cell has the [111] orientation shown in Fig. 5, each of the side surfaces of the unit cell 90 extends at an acute angle relative to the longitudinal central axis 118. A line 147 extending between diagonally opposite corners of the unit cell having the [111] orientation is parallel to the axes 118 and 66. Although only a single unit cell 90 has been shown in Fig. 5, it should be understood that other unit cells of the elongated crystals 116 have the same longitudinal orientation. Within an individual elongated crystal 116 all unit cells also share a common rotational orientation about the longitudinal central axis 118 such that the corresponding side surfaces of all unit cells are parallel. Although other elongated crystals 116 need not share the same rotational orientation, a common longitudinal orientation of [111] exists, imparting within the central portion of the blade 72 and correspnding airfoil 76 a common set of Young's modulus and other mechanical·behavior characteristics along the longitudinial central axis 118.

The face-centered cubic unit cell 90 has a rectangular array of sides 142, 144, 146 and 148 which extend perpendicular to sides 150 and 152. The sides 142-152 all extend at acute angles relative to the central axes of the elongated metal crystals 116 and the central axis 118 of the airfoil and blade. The resulting cornerwise orientation of the unit cell 90 enhances the strength or elastic modulus of the central portion of the airfoil.

Although only the unit cells 88 and 90 for the leading edge portion 78 and central portion 84 of the airfoil 76 have been illustrated in Figs. 4 and 5, it should be understood that the unit cells 102 and 112 of the starter element 50 have a similar construction and are similarly longitudinally oriented relative to the elongated metal crystals 62 of the starter element. It should also be understood that the unit cell 106 for the metal crystals 62 in the portion 104 of the starter element 50 (see Fig. 2) have the same longitudinal orientation as the unit cells 102 in the portion 98 of the starter element and the unit cells 88 in the airfoil 76.

Airfoil Containg Article-Second Embodiment

In the embodiment of the invention illustrated in Figs. 1-5, the blade 72 has a construction in which there is a large number of parallel elongated metal crystals 116 in the leading and trailing edge portions 78 and 80 of the airfoil and central portion 84 of the airfoil.  However, it is contemplated that the advantages which result from forming a cast article with unit cells having different orientations could be achieved with cast articles having a smaller number of metal crystals.  Thus, different portions of the cast article having unit cells with different orientations could each be formed as a single crystal.  When this is to be done, the starter element has a plurality of portions formed of single crystals which effect nucleation of corresponding portions of the cast article.

A starter element 170 (Fig. 6) for use in casting an article having portions with different unit cell orientations formed as single crystals is illustrated in Fig. 6.  The starter element 170 is disposed at the lower end portion of a mold cavity 38.  The starter element 170 is exposed to both the chill 42 and to the mold cavity 38.  Thus, a lower or bottom side surface 174 of the starter element 170 is disposed in abutting engagement with the upper surface 176 of the chill 42.  The opposite side surface 178 of the starter element 170 is exposed directly to the mold cavity 38.

When molten metal is poured into the mold cavity 38, the molten metal flows downwardly against the upper side surface 178 of the starter element 170. Due to the rapid conduction of heat from the starter element 170 to the chill 42, solidification of the molten metal in the mold cavity 38 is initiated at the upper side surface 178 of the starter element 170. As solidification of the molten metal proceeds upwardly in the mold cavity 38, the chill 42 and mold 10 may be lowered to withdraw the mold from the furnace 12.

The starter element 170 is used to effect solidification of molten metal in the mold cavity 38 to form a blade 184. The blade 184 has a base 186 and a airfoil 188 with configurations which correspond to the configurations of the mold cavity 38.

In accordance with a feature of this embodiment of the invention, a leading edge portion 192 of the airfoil 188 is formed as a single crystal. Similarly, a trailing edge portion 194 of the airfoil 188 is formed as a single crystal. The single crystal leading and trailing edge portions 192 and 194 of the airfoil 188 have cubic unit cells, indicated schematically at 196 and 198 (Fig. 7) which have the same [001] orientation as the unit cells 88 and 92 (Fig. 3) of the leading and trailing edge portions 78 and 80 of the airfoil 76. However, the leading and trailing edge portions 192 and 194 (Fig. 7) of the airfoil 188 are each formed as a single crystal rather than as a plurality of elongated crystals as are the edge portions 78 and 80 of the airfoil 76.

The single crystal edge portions 192 and 194 of the airfoil 188 are interconnected by a single crystal central portion 202 (Fig. 7) which extends between the single crystal leading and trailing edge portions 192 and 194. It should be noted that for the article shown the leading edge portion 192, the trailing edge portion 194, and the central portion 202 of the airfoil 188 extend through the base portion 186. The cubic unit cells 206 of the single crystal central portion 202 have a [111] orientation which is the same as the orientation of the unit cell 90 (Figs. 3 and 5) of the central portion 84 of the blade 72. By forming each of the portions 192, 194 and 202 of the blade 184 as single crystals, many of the well known advantages of single crystal airfoil construction are obtained.

Since the single crystal leading and trailing edge portions 192 and 194 have a unit cell orientation which is different from the unit cell orientation of the single crystal central portion 202 of the blade, different portions of the blade have different physical characteristics to enhance the overall operating characteristics of the blade. Thus, the [001] orientation of the unit cells 196 and 198 enhances the thermal fatigue resistance of the single crystal leading and trailing edge portions 192 and 194. The [111] orientation of the unit cells 206 enhances the strength and Young's modulus of the single crystal central portion 202.

The starter element 170 (Fig. 6) is formed with a plurality of single crystal portions which effect nucleation of the single crystal portions of the blade 184. Thus, the starter element 170 has a single crystal portion 210 which effects nucleation of the single crystal leading edge portion 192 (Fig. 7) of the blade 184. A single crystal portion 212 of the starter element 170 effects nucleation of the single crystal trailing edge portion 194 of the blade 184.

The single crystal portions 210 and 212 of the starter element 170 are formed of unit cells having the same orientation as the unit cells of the single crystal leading and trailing edge portions 192 and 194 of the airfoil. Thus, the face-centered cubic unit cells of the single crystal portions 210 and 212 of the starter element 170 are indicated schematically at 214 and 216 and have an [001] orientation. The cubic unit cells 214 and 216 have upper and lower sides which extend perpendicular to the central axis 66 of the mold cavity 38 and four sides disposed in a rectangular array and extend parallel to the central axis 66 of the mold cavity 38.

The single crystal side portions 210 and 212 of the starter element 170 are interconnected by a single crystal central portion 220. The cubic unit cells 224 of the single crystal central portion 220 have a [111] orientation. Thus, the unit cells 224 of the single crystal central portion 220 have an orientation which is
the same as the orientation of the unit cell 90 of Fig.
5. The sides of the unit cells 224 are all skewed or
extend at an acute angle relative to the central axis 66.

When molten metal solidifies against the upper side
surface 178 of the starter element 170, the single crystal
portion 210 of the starter element nucleates the single
crystal leading edge portion 192 of the blade 184. The
single crystal which forms the leading edge portion 192 of
the airfoil 188 has unit cells with the same
crystallographic orientation as the unit cells of the
portion 210 of the starter element 170, that is a [001]
orientation. Similarly the portion 212 of the starter
element 170 nucleates a single crystal which forms the
trailing edge portion 194 of the airfoil 188. The single
crystal trailing edge portion 194 of the airfoil 188 has
unit cells 198 with the same orientation as the unit cells
216 of the portion 212 of the starter element 170.

The central portion 220 of the starter element 170
nucleates a single crystal 202 which forms the central
portion of the blade 184 and extends between the leading
and trailing edge portions 192 and 194. The single
crystal 202 is nucleated with unit cells having the same
orientation as the unit cells of the central portion 220
of the starter element 170, that is with unit cells having
a [111] orientation.

-32- 0066971

Summary

In view of the foregoing it is apparent that the present invention provides a new and improved method of forming new and improved cast metal articles. Although it is contemplated that many different improved articles could be formed with the improved method, the method is advantageously used to form blades 72, 184 which can be used in gas turbine engines. The improved cast article, whether it be a blade 72, 184 or other object, is provided with portions having unit cells 88, 90, 92, 196, 198, 206 with different orientations. This is achieved by initiating solidification of the article during a casting operation with a starter element 50, 170 having crystals with unit cells 102, 106, 112, 214, 216, 224 oriented in different directions. The different directions of orientation of the unit cells in the starter elements 72, 184 results in nucleation and growth of crystals 116, 192, 194, 202 in the cast articles having unit cells with different orientations in different portions of the article.

The operating characteristics of the articles 72, 184 are enhanced by forming the airfoils with leading and/or trailing edge portions 78, 80, 192, 194 with unit cells oriented in one direction and central portions 84, 202 with unit cells oriented in another direction. Thus, an blade 72 or 184 can be cast with the airfoil leading and/or trailing edge portions having unit cells 88, 92, 196, 198 oriented in an [001] direction to enhance thermal fatigue resistance of the leading and/or trailing edge portions. Although the [001] unit cell orientation is advantageous from a thermal fatigue standpoint, it is not optimal from a creep strength or Young's modulus standpoint. In order to achieve better strength and stiffness, the central portion of the blade and associated airfoil advantageously has unit cells 99, 206 oriented in the [111] direction.

An airfoil having leading and/or trailing edge portions with unit cells oriented in the [001] direction and a central portion oriented in the [111] direction can advantageously be cast with each of the portions being formed of either a plurality of elongated crystals (Fig. 3) or a single crystal (Fig. 7). When the article, such as blade 72, is cast with the leading and trailing edge portions 78, 80 and central portion 84 being formed of elongated crystals 116, the longitudinal axes of the crystals extend parallel to each other and to the central axes of the edge portions and central portion of the blade. When the article, such as blade 184 is formed with single crystal portions, the central portion 202 and the leading and/or trailing edge portion 192, 194 of the airfoil 184 are each formed as single crystals. This can result in the airfoil being formed of three single crystals, that is a single crystal leading edge portion 192, a single crystal trailing edge portion 194, and a single crystal central portion 202 extending between the leading and trailing edge portions.

0066971

- 35 -

CLAIMS:

1.    A method of casting an article having a first portion formed of metal crystal unit cells oriented in a first direction and a second portion formed of metal crystal unit cells oriented in a second direction which extends transverse to the first direction, said method comprising the steps of providing a starter element having a first portion formed of metal crystal unit cells oriented in the first direction and a second portion formed of metal crystal unit cells oriented in the second direction which extends transverse to the first direction, providing a chill, providing a mold having an open end portion and a cavity in which the article is to be cast, positioning the starter element in the mold with the first and second portions of the starter element each exposed to both the chill and the mold cavity, pouring molten metal in the mold cavity, engaging the first portion of the starter element with the molten metal and initiating the formation in the mold cavity of metal crystal unit cells oriented in the first direction, and engaging the second portion of the starter element with the molten metal and initiating the formation in the mold cavity of metal crystal having unit cells oriented in the second direction.

2. A method as set forth in claim 1 wherein said step of providing a starter element includes the step of providing a starter element in which the metal crystal cubic unit cells of the first portion of the starter element are oriented with an [001] direction and the metal crystal unit cells of the second portion of the starter element are oriented with a [111] direction, both directions being parallel to the longitudinal axis of the article.

3. A method as set forth in claim 1 wherein said steps of initiating the formation of metal crystal unit cells oriented in the first and second directions includes the step of initiating the formation of elongated metal crystals having longitudinal axes which extend parallel to each other.

4. A method as set forth in claim 1 wherein said step of initiating the formation of metal crystal unit cells oriented in the first direction includes the step of initiating the formation of only a first single metal crystal from the first portion of the starter element with unit cells in the first metal crystal oriented in the first direction and said step of initiating the formation of metal crystal unit cells oriented in the second direction includes the step of initiating the formation of only a second single metal crystal from the second portion of the starter element with unit cells in the second metal crystal oriented in the second direction.

5.    A method as set forth in claim 1 wherein said step of providing a starter element having first and second portions includes the step of providing a starter element in which the first and second portions are each formed of a plurality of elongated metal crystals, said step of initiating the formation of metal crystal unit cells oriented in the first direction includes the step of initiating the formation of a first plurality of elongated metal crystals which extend upwardly from ends of the elongated metal crystals in the first portion of the starter element, said step of initiating the formation of metal crystal unit cells oriented in the second direction includes the step of initiating the formation of a second plurality of elongated metal crystals which extend upwardly from ends of the elongated metal crystals in the second portion of the starter element.

6.    A method of casting an airfoil having leading and trailing edge portions interconnected by a central portion, said method comprising the steps of providing a starter element having a first portion with cubic unit cells oriented in an [001] direction and a second portion with cubic unit cells oriented in a [111] direction, providing a chill, providing a mold having an open end portion and a cavity with a configuration corresponding to the configuration of the airfoil, positioning the starter element in the mold with the starter element exposed to both the chill and the mold cavity, pouring molten metal into the mold cavity, engaging the first and second portions of the starter element with the molten metal, and solidifying the molten metal in the mold cavity to form the airfoil, said step of solidifying the molten metal in the mold cavity including the steps of solidifying the molten metal in the portion of the mold cavity having a configuration corresponding to the configuration of one of the edge portions of the airfoil with unit cells oriented in an [001] direction and solidifying the molten metal in the portion of the mold cavity having a configuration corresponding to the configuration of the central portion of the airfoil with unit cells oriented in a [111] direction.

7. A method as set forth in claim 6 wherein said step of solidifying the molten metal in the mold cavity further includes the step of solidifying the molten metal in the portion of the mold cavity having a configuration coresponding to the configuration of the other edge portion of the airfoil with unit cells oriented in an [001] direction.

8. A method as set forth in claim 6 wherein said step of solidifying the molten metal in the mold cavity further includes the step of solidifying the molten metal as elongated crystals having parallel longitudinal axes.

9. A method as set forth in claim 6 wherein said step of soldifying the molten metal further includes the step of forming the one edge portion of the airfoil as a single crystal.

10. A method as set forth in claim 9 wherein said step of solidifying the molten metal includes solidifying the central portion of the airfoil as a single crystal.

11. A method of casting an airfoil having leading and trailing edge portions interconnected by a central portion, said method comprising the steps of providing a starter element, providing a chill, providing a mold having an open end portion and a cavity with a configuration corresponding to the configuration of the airfoil, positioning the starter element in the mold with the starter element exposed to both the chill and the mold cavity, pouring molten metal into the mold cavity, and solidifying the molten metal in the mold cavity to form the airfoil, said step of solidifying the molten metal including the steps of forming the leading edge portion of the airfoil as a first single crystal, forming the trailing edge portion of the airfoil as a second single crystal, and forming the central portion of the airfoil as a third single crystal which extends between the first and second single crystals.

12. A method as set forth in claim 19 wherein said step of providing a starter element includes providing a starter element having three portions each of which is formed as a single crystal, said step of solidifying the molten metal further including the steps of engaging a first one of the three single crystal portions of the starter element with the molten metal and initiating the formation of the first single crystal in the portion of the mold cavity having a configuration corresponding to the configuration of the leading edge portion of the airfoil, engaging a second one of the three single crystal portions of the starter element with the molten metal and initiating the formation of the second single crystal in the portion of the mold cavity having a configuration corresponding to the configuration of the trailing edge portion of the airfoil, and engaging a third one of the three single crystal portions of the starter element with the molten metal and initiating the formation of the third single crystal in the portion of the mold cavity having a configuration corresponding to the configuration of the central portion of the airfoil.

13. A method as set forth in claim 11 wherein said step of forming the leading edge portion of the airfoil as a first single crystal includes the step of forming the first single crystal with unit cells extending in a first direction, said step of forming the central portion of the airfoil as a third single crystal includes the step of forming the third single crystal with unit cells extending in a second direction transverse to the first direction.

14. A method as set forth in claim 13 wherein said step of forming the trailing edge portion of the airfoil as a second single crystal includes the step of forming the second single crystal with unit cells extending in the first direction.

15. An airfoil comprising a leading edge portion, said leading edge portion being formed of a first plurality of elongated metal crystals, each crystal of said first pluralitly of elongated metal crystals being formed of a plurality of cubic unit cells oriented in a first direction, a trailing edge portion formed of a second pluralitly of elongated metal crystals, each crystal of said second plurality of elongated metal crystals being formed of a plurality of cubic unit cells oriented in the first direction, and a central portion extending between said leading and trailing edge portions and formed of a third plurality of elongated metal
crystals, each crystal of said third plurality of
elongated metal crystals being formed of a plurality of
cubic unit cells oriented in a second direction which
extends transversely to said first direction.

16. An airfoil as set forth in claim 15 wherein each
of the unit cells of the first and second pluralities of
crystals are oriented in the ·[001] direction and each of
the unit cells of the third plurality of crystals is
oriented in the [111] direction.

17. An airfoil as set forth in claim 15 wherein the
longitudinal axes of the elongated crystals of the first,
second and third pluralities of elongated crystals extend
parallel to each other.

18. An airfoil comprising a leading edge portion
formed as a first single crystal, a trailing edge portion
formed as a second single crystal, and a central portion
formed as a third single crystal and extending between
said first and second single crystals.

19. An airfoil as set forth in claim 18 wherein said
first and second single crystals have unit cells oriented
in an [001] direction and said third single crystal has
unit cells oriented in the [111].

20. An airfoil as set forth in claim 18 wherein said airfoil has tip and root end portions, said first, second and third single crystals each extending from the root end portion of the airfoil to the tip end portion of the airfoil.

21. A method of casting an airfoil having a longitudinally extending leading edge portion, a longitudinally extending trailing edge portion and a central portion extending between said leading and trailing edge portions, said method comprising the steps of providing mold having a cavity at least a portion of which has a configuration corresponding to the configuration of the airfoil, providing a starter element having a first portion formed wih a plurality of cubic unit cells having a first orientation and a second portion having a plurality of cubic unit cells with a second orientation which is different than said first orientation, positioning the mold and starter element relative to each other with the first and second portions of the starter element exposed to the mold cavity, pouring molten metal into the mold cavity, said step of pouring molten metal into the mold cavity including the step of engaging the first and second portions of the starter element with the molten metal, solidifying the molten metal in the mold cavity, said step of solidifying the

molten metal including the steps of solidifying molten metal to form one of the edge portions of the airfoil with cubic unit cells having the first orientation and solidifying the molten metal to form the central portion of the airfoil with cubic unit cells having the second orientation.

22. A method as set forth in claim 21 wherein said step of providing a starter element includes the step of providing a starter element having a third portion formed with a plurality of cubic unit cells having the first orientation, said step of positioning the mold and starter element relative to each other including the step of positioning the starter element with the third portion exposed to the mold cavity, said step of pouring molten metal into the mold cavity including the step of engaging the third portion of the starter element with the molten metal, said step of solidifying the molten metal including the step of solidifying molten metal to form the other one of the edge portions of the airfoil with cubic unit cells having the first orientation.

23. A method as set forth in claim 21 wherein the step of solidifying molten metal to form one of the edge portions of the airfoil includes solidifying the molten metal to form a plurality of elongated metal crystals having substantially parallel longitudinal axes.

24. A method as set forth in claim 21 wherein the step of solidifying molten metal to form one of the edge portions includes solidifying the molten metal to form a single crystal having the configuration of the one edge portion of the airfoil.

25. A method as set forth in claim 21 wherein the step of solidifying molten metal to form the one edge portion of the airfoil includes solidifying the molten metal with some of the sides of the cubic unit cells extending substantially parallel to the longitudinal axis of the one edge portion.

26. A method as set forth in claim 25 wherein the step of solidifying the molten metal to form the central portion of the airfoil includes solidifying the molten metal with all of the sides of the cubic unit cells extending transversely to the longitudinal axis of the one edge portion.

27. A metal airfoil comprising a leading edge portion, a trailing edge portion, and a central portion extending between said leading and trailing edge portions and having a central axis, one of said edge portions being formed of cubic unit cells each of which has a plurality of sides extending perpendicular to the central axis of the central portion and a plurality of sides extending parallel to the central axis of the central portion, said central portion being formed of cubic unit cells all of the sides of which extend at an acute angle to the central axis of said central portion.

28. An airfoil as set forth in claim 27 wherein the other one of said edge portions is formed of cubic unit cells each of which has a plurality of sides extending perpendicular to the central axis of the central portion and a plurality of sides extending parallel to the central axis of the central portion.

29. An airfoil as set forth in claim 28 wherein said leading and trailing edge portions and said central portion are formed of elongated metal crystals in which unit cells are disposed, said elongated metal crystals having longitudinal axes extending parallel to the central axis of the central portion.

30. An airfoil as set forth in claim 28 wherein said leading edge portion is formed as a first single crystal in which unit cells are disposed and said trailing edge portion is formed as a second single crystal in which unit cells are disposed.

0066971

1/3

FIG.1

FIG.2

FIG.3

FIG.4

FIG.5

0066971

FIG.6

FIG.7